Europäisches Patentamt

(19) European Patent Office

Office européen des brevets

(11) **EP 0 793 274 A1**

(12) **EUROPEAN PATENT APPLICATION**

(43) Date of publication:
03.09.1997 Bulletin 1997/36

(51) Int. Cl.$^6$: **H01L 27/115**, H01L 27/12

(21) Application number: 97102512.7

(22) Date of filing: 17.02.1997

(84) Designated Contracting States:
**DE FR GB IT**

(30) Priority: 01.03.1996 US 609695

(71) Applicant: **MOTOROLA, INC.**
Schaumburg, IL 60196 (US)

(72) Inventors:
• **Jones, Robert E. Jr.**
**Austin, Texas 78750 (US)**
• **Paulson Wayne M.**
**Austin, Texas 78746 (US)**

(74) Representative: **Spaulding, Sarah Jane et al**
**Motorola,**
**European Intellectual Property Operations,**
**Midpoint,**
**Alencon Link**
**Basingstoke, Hampshire RG21 7PL (GB)**

(54) **Ferroelectric nonvolatile memory cell and a process for forming the memory cell**

(57) An FENVM array is formed over an insulating layer (32) that is part of a substrate. The insulating layer (32) contacts the source/drain regions (54, 55, 56, 57, 134, 136, 138, 140, 142, 144, 146) of transistors within the memory array to reduce the likelihood that data within memory cells of the array will be disturbed under common biasing conditions. The junction capacitance of the source/drain regions (54, 55, 56, 57, 134, 136, 138, 140, 142, 144, 146) of the transistors is reduced because the source/drain regions (54, 55, 56, 57, 134, 136, 138, 140, 142, 144, 146) contact the insulating layer (32). The memory cells have a shorter read (access) and write time compared to memory cell formed within bulk substrates. Guard rings and other structures required to reduce the likelihood of latch up are not necessary. In one embodiment, field isolation regions do not laterally surround each active region for transistors between memory cells. Therefore, a significantly smaller memory array can be obtained.

*FIG.8*

# Description

## Field of the Invention

The present invention relates to semiconductor memory devices, and in particular, ferroelectric non-volatile memory cells.

## Background of the Invention

A ferroelectric non-volatile memory (FENVM) cell can have one transistor and one capacitor. However, a one transistor-one capacitor cell suffers from a problem with writing symmetric data into the capacitor. For example, when the bit line and word line are high (i.e., at $V_{CC}$) and the drive line is low, the potential across the ferroelectric capacitor is not $V_{CC}$ but is approximately $V_{CC}$ minus the threshold voltage of the transistor. The opposite polarity can be written with the potential difference across the ferroelectric capacitor being -$V_{CC}$ when the bit line is low, the drive line is at $V_{CC}$ and the word line is at $V_{CC}$. This writing problem becomes greater as $V_{CC}$ is reduced (closer to 0 volts) for low voltage, low power circuits.

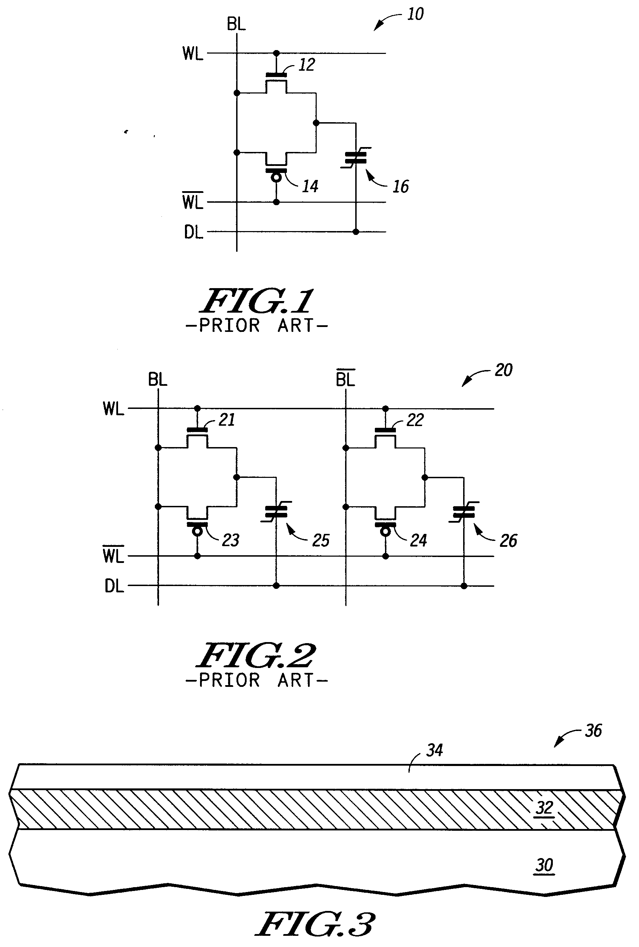

Two approaches can be used to solve the symmetric writing problem. First, the word line voltage can be boosted. However, this requires extra circuitry, and the power consumption of the device is increased. The second solution is to use complementary pairs of access transistors with a ferroelectric capacitor for each complementary pair, such as those shown in FENVM cells 10 and 20 in FIGs. 1 and 2.

In FIG 1, the memory cell 10 includes an n-channel transistor 12, a p-channel transistor 14, and a ferroelectric capacitor 16. A bit line (BL) is coupled to source/drains of transistors 12 and 14. The other source/drains of transistors 12 and 14 are coupled to an electrode of ferroelectric capacitor 16. The gate of transistor 12 is part of a word line (WL), and the gate of transistor 14 is part of a complementary word line ($\overline{WL}$). The other electrode of ferroelectric capacitor 16 is coupled to a drive line (DL).

FIG. 2 has two n-channel transistors 21 and 22, two p-channel transistors 23 and 24, and two ferroelectric capacitors 25 and 26. A bit line (BL) is coupled to source/drains of transistors 21 and 23. The other source/drains of transistors 21 and 23 are coupled to an electrode of ferroelectric capacitor 25. The gates of transistors 21 and 22 are part of a word line (WL), and the gates of transistors 23 and 24 are part of a complementary word line ($\overline{WL}$). A complementary bit line ($\overline{BL}$) is coupled to source/drains of transistors 22 and 24 as shown in FIG. 2. The other source/drains of transistors 22 and 24 are coupled to an electrode of ferroelectric capacitor 26. The other electrodes of capacitors 25 and 26 are connected to a drive line (DL).

The memory cells 10 and 20 require a relatively large area when a conventional silicon wafer is used. The area penalty is related to separating active regions to avoid latch up. Leakage currents from reverse diode leakage in the source/drains that are connected to the storage node can result in charging of the storage node and data reversal, even during standby, can occur. Accordingly, a need exists for a ferroelectric cell which can be written symmetrically and which also exhibits low leakage.

## Brief Description of the Drawings

The present invention is illustrated by way of example and not limitation in the figures of the accompanying drawing, in which like references indicate similar elements, and in which:

FIG. 1 includes a circuit diagram of a two transistor and one capacitor FENVM cell (prior art);

FIG. 2 includes a circuit diagram of a four transistor and two capacitor FENVM cell (prior art);

FIG. 3 includes an illustration of a cross-sectional view of a portion of semiconductor substrate;

FIG. 4 includes an illustration of a cross-sectional view of the substrate of FIG. 3 after forming field isolation regions and doping portions of a silicon layer overlying an insulating layer;

FIG. 5 includes an illustration of a cross-sectional view of the substrate of FIG. 4 after forming two transistors;

FIG. 6 includes an illustration of a cross-sectional view of the substrate of FIG. 5 after forming a ferroelectric capacitor over an insulating layer;

FIG. 7 includes a cross-sectional view of a portion of the substrate of FIG. 6 after forming a substantially completed FENVM cell in accordance with one embodiment of the present invention;

FIG. 8 includes an illustration of a cross-sectional view of a portion of a semiconductor substrate including a FENVM cell in accordance with another embodiment of the present invention;

FIG. 9 includes an illustration of a cross-sectional view of a portion of the substrate of FIG. 3 after a doping step;

FIG. 10 includes an illustration of a cross-sectional view of the substrate of FIG. 9 after forming four transistors;

FIG. 11 includes an illustration of a cross-sectional view of the substrate of FIG. 10 after forming conductive members over the source/drain regions;

FIG. 12 includes an illustration of a cross-sectional view of the substrate of FIG. 11 after forming an insulating layer and contact plugs;

FIG. 13 includes an illustration of a cross-sectional view of the, substrate of FIG. 12 after forming ferroelectric capacitors;

FIG. 14 includes an illustration of a cross-sectional view of the substrate of FIG. 13 after forming a first level of interconnects;

FIG. 15 includes an illustration of a cross-sectional view of the substrate of FIG. 14 after forming a substantially completed device in accordance with the present invention;

FIG. 16 includes an illustration of a cross-sectional view of a portion of a substantially completed device in accordance with another embodiment of the present invention; and

FIG. 17 includes an illustration of a top view of portion of an FENVM array.

Skilled artisans appreciate that elements in the figures are illustrated for simplicity and clarity and have not necessarily been drawn to scale. For example, the dimensions of some of the elements in the figures are exaggerated relative to other elements to help to improve understanding of embodiment(s) of the present invention.

Detailed Description

An FENVM array is formed over an insulating layer that is part of a substrate. The insulating layer contacts the source/drain regions of transistors within the memory array to reduce the likelihood that data within memory cells of the array will be disturbed under common biasing conditions. The junction capacitance of the source/drain regions of the transistors is reduced because the source/drain regions contact the insulating layer. The memory cells have a shorter read (access) time compared to memory cell formed within bulk substrates. Guard rings and other structures required to reduce the likelihood of latch up are not necessary. In one embodiment, active regions within the memory array are formed as strips. Field isolation regions are not formed along those active region between transistors of different memory cells. Therefore, a significantly smaller memory array can be obtained. The present invention is better understood with the embodiments described below.

FIG. 3 includes a cross-sectional view of a portion of a substrate 36 that includes a semiconductive base material 30, an insulating layer 32 and a semiconductor layer 34. In one embodiment, the semiconductive base material is a silicon wafer, the insulating layer 32 is an oxide layer or a nitride layer that has been formed beneath an essentially monocrystalline silicon layer 34. The substrate as shown in FIG. 3 may be formed by a conventional separation by implanting oxygen (SIMOX) or wafer bonding method. The silicon layer 34 may be n-type or p-type doped. The thickness of silicon layer 34 is typically in a range of approximately 100-2000 angstroms thick, and more commonly, in a range of approximately 400-1000 angstroms thick. If fully depleted transistors are to be formed, the thickness of the silicon layer 34 is typically no greater than 600 angstroms thick.

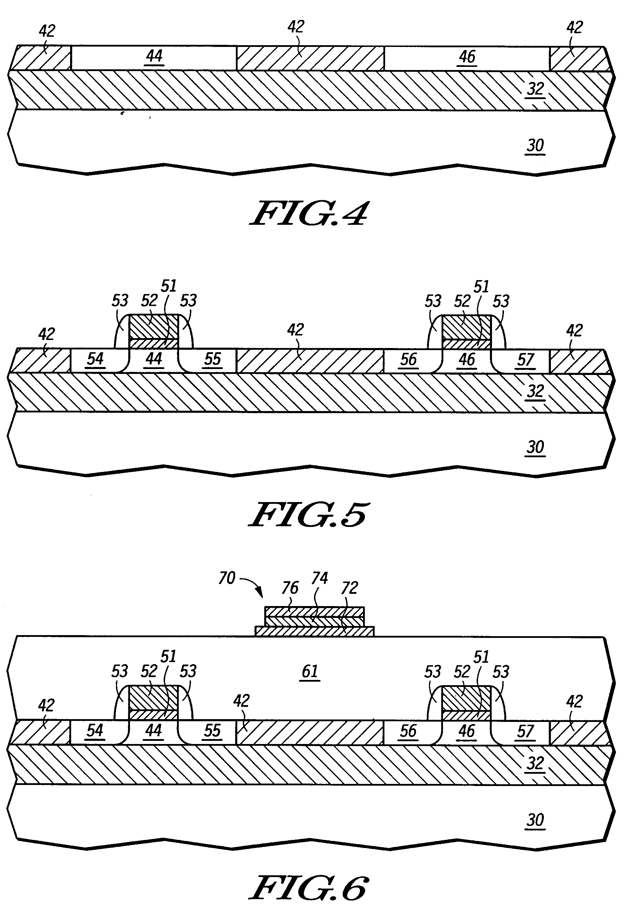

Field isolation regions 42 are formed to isolate the silicon layer 34 into active regions 44 and 46. In a subsequent step, one or both of the active regions 44 and 46 is doped with a p-type or n-type dopant. As illustrated in FIG. 4, active region 44 is p-type doped and active region 46 is n-type doped. The doping level within the regions 44 and 46 are typically determined by the threshold voltages of transistors that will be formed within those active regions.

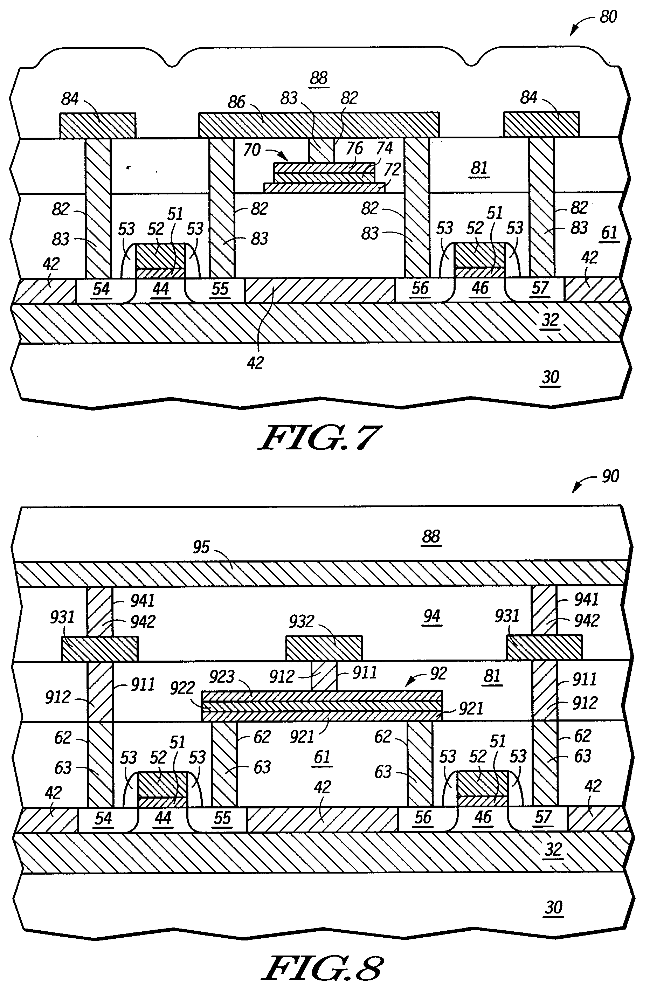

A gate dielectric layer 51 is formed over the active regions 44 and 46 as shown in FIG. 5. The gate dielectric layer can include an oxide, an oxide-nitride compound, or a plurality of oxide or nitride and oxide layers. A conductive layer is then formed over the gate dielectric layer 51 and is patterned to form gate electrodes 52. As illustrated in FIG. 5, the gate electrodes can include silicon, a silicide or a conductive material. If polysilicon is used near the gate dielectric layer, gate electrodes 52 could be n-type doped over active region 44 and a p-type doped over active region 46, or all gate electrodes 52 can be n-type doped or p-type doped. During the patterning step to form the gate electrodes 52, the gate dielectric layer 51 is also patterned to remove that portion of the gate dielectric layer 51 not covered by the gate electrodes 52.

Insulating spacers 53 are then formed adjacent to the gate electrodes as illustrated in FIG. 5. The insulating spacers 53 include nitride, oxide, or the like and are typically formed by depositing a conformal layer and then anisotropically etching back that layer to form the sidewall spacers 53 as shown in FIG. 5. Following the formation of the spacers 53, the source/drain regions 54-57 are formed. Doped regions 54 and 55 are formed using an n-type dopant to make heavily doped $N^+$ regions 54 and 55 within active region 44. The portion of active region 44 that lies between the source/drain regions 54 and 55 forms the channel region of the transistor illustrated. Within this specification, heavily doped means that the doping concentration of that particular region or layer is at least 1E19 atoms per cubic centimeter or higher. Similarly, $P^+$ source/drain regions 56 and 57 are formed by implanting a p-type dopant within active region 46. Therefore, as illustrated in FIG. 5, n-channel and p-channel transistors have been formed.

An insulating layer 61 is formed over the gate electrodes 52 in the active regions 44 and 46 as shown in FIG. 6. The insulating layer may include one or more films. For example, an undoped insulating film could be formed over the active regions which is then covered by a doped insulating film. The doped insulating film includes boron, phosphorus, or the like or other dopants. The insulating films may include oxide, nitride, or the like. Further, the insulating layer 61 may include an insulative adhesion or barrier film near its upper surface. This adhesion or barrier film can include titanium dioxide, tantalum pentoxide, or the like. For simplicity, the insulating layer 61 is illustrated as a single layer as to simplify understanding of the invention.

A lower conductive layer 72, ferroelectric layer 74, and an upper conductive layer 76 are formed over the insulating layer 61 as shown in FIG. 6. The conductive layers 72 and 76 include platinum, ruthenium, rhenium, osmium, iridium, or any of their conductive metal oxides. The ferroelectric layer 74 can include lead zirconate titanate, lanthanum-doped lead zirconate titanate, barium strontium titanate, strontium bismuth niobate, strontium bismuth tantalate, strontium bismuth niobate tantalate, or any other material capable of producing a hysterisis curve when properly oxidized. The ferroelectric and upper conductive layers 74 and 76 are patterned to generally correspond to the shape of the ferroelectric capacitor. The lower conductive layer 74 is then patterned to form the drive line for the memory cell. The portions of conductive layers 72 and 76 that lie adjacent to the patterned ferroelectric layer 74 form the electrodes for the ferroelectric capacitor 70. In another embodiment, the layers 72, 74, and 76 can be patterned into strips, and layers 74 and 76 can be subsequently patterned to define the ferroelectric capacitors.

An oxidation cycle is performed to allow the ferroelectric layer to exhibit ferroelectric properties. The oxidation cycle is typically performed at a temperature in a range of approximately 500-850 degrees Celsius for a time in a range of approximately 1-120 minutes. The oxidation cycle can be performed before or after patterning the ferroelectric layer 74.

An insulating layer 81 is formed over insulating layer 61 and the ferroelectric capacitor 70 as shown in FIG. 7. The insulating layer can include any of the films or materials that could be used to form the insulating layer 61. However, with insulating layer 81, if an adhesion or barrier film is used, it would be the first (lowest lying) film in insulating layer 81 and would contact the ferroelectric capacitor 70.

Contact openings 82 are formed in the insulating layers 81 and 61 to the source/drain regions 54-57 and in the insulating layer 81 to the electrodes of ferroelectric capacitor 62 as shown in FIG. 7. These contact openings 82 are then filled with a conductive material to form conductive plugs 83. The conductive plugs are formed using conventional materials and methods used by those skilled in the art. Interconnects 84 and 86 are then formed over the conductive plugs 83. The interconnects 84 will form the bit line for the memory cell and the interconnect 86 is a portion of the storage node for the memory cell. The interconnects 84 and 86 include aluminum, copper, or the like. The interconnects 84 and 86 can include adhesion, barrier, or antireflective films. A passivation layer 88 is formed over the interconnects by depositing an oxide film, nitride film, an oxynitride film, or a combination of these films. In one non-limiting embodiment, a phosphorous doped glass film overlies the interconnects that is then covered by a plasma enhanced nitride film.

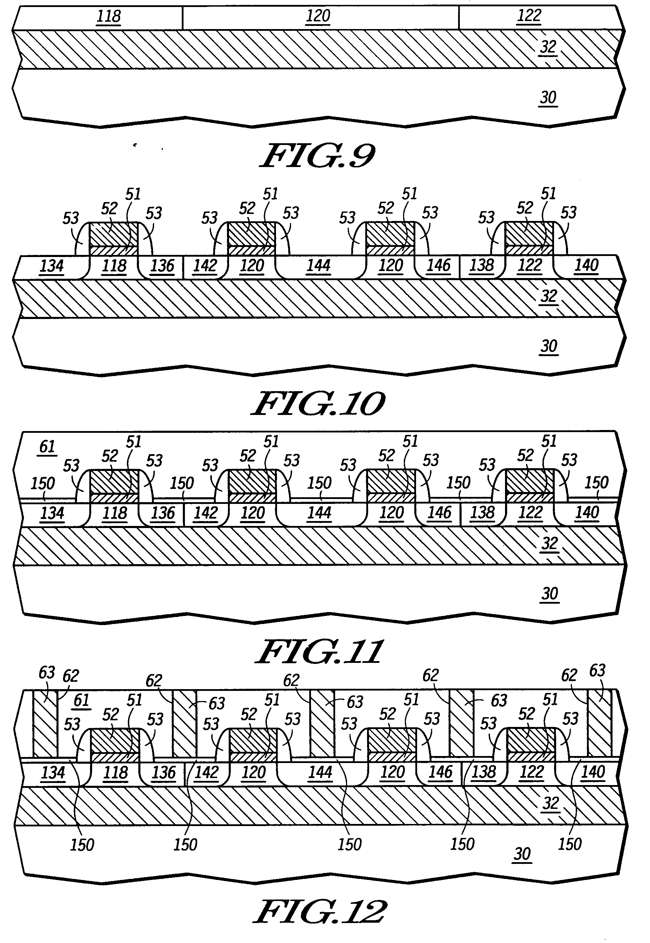

Another FENVM cell 90 is shown in FIG. 8. The memory cell 90 is similar to the one shown in FIG. 8 except that the drive line overlies the ferroelectric capacitor 70. After forming insulating layer 61, openings 62 and conductive plugs 63 are formed using conventional methods. After forming contact openings 62 and conductive plugs 63, the ferroelectric capacitor 92 is then formed. The ferroelectric capacitor 92 includes a lower electrode 921, a ferroelectric layer 922 and an upper electrode layer 923. These are formed using similar materials and methods used to form the ferroelectric capacitor 70 as illustrated in FIGs. 6 and 7. However, unlike ferroelectric capacitor 70, the lower conductive layer 92 is not patterned into a drive line. Therefore, layers 921-923 can be patterned using the same mask.

Insulating layer 81 is formed over the ferroelectric capacitor 92 and insulating layer 61 as shown in FIG. 8. Openings 911 are then formed through the insulating layer 81 and are filled with conductive plugs 912. Interconnects 931 and 932 are then formed over the insulating layer 81. Interconnects 931 and 932 are formed such that interconnect 931 forms a landing pad upon which the subsequent conductive plugs land and interconnect 932 is electrically connected to other portions of conductive layer 923 from different ferroelectric capacitors (not shown in FIG. 8) to form a drive line for the memory cell.

An insulating layer 94 is then formed over the interconnects 931 and 932 and insulating layer 81 as shown in FIG. 8. The insulating layer 94 is patterned to form via openings 941 extending down to interconnects 931. These openings are filled with conductive plugs 942. An interconnect 95 is formed over the insulating layer 94 and the conductive plugs 942. Interconnect 95 is part of a bit line for the memory cell 90. Overlying the interconnect 95 is passivation layer 88.

The conductive plugs 63, 912, and 942, conductive layers 921 and 923, ferroelectric layer 922, insulating layer 94, and interconnects 931, 932, and 95 can use materials described for conductive plugs 82, conductive layers 72 and 76, ferroelectric layer 74, insulating layer 61, and interconnects 84 and 88, respectively.

Another embodiment is illustrated having silicided source/drain regions and no field isolation between memory cells lying along the same row or column. The silicon layer 34 of substrate 36 shown in FIG. 3 is doped to form a p-type active region 120 and n-type active regions 118 and 122 as shown in FIG. 9. When forming active regions 118, 120, and 122, the doping concentrations are selected to achieve the proper threshold voltage for transistors that are subsequently formed within the active regions 118, 120, and 122. In one embodiment, only active region 118 or only active regions 120 and 122 are doped. In another embodiment, both conductivity type active regions are doped, but during different doping steps.

A gate dielectric layer 51, gate electrodes 52, and insulating spacers 53 are formed over the active regions 118, 120, and 122 as shown in FIG. 10. P$^+$ source/drain regions 134, 136, 138, and 140 are formed within active regions 118 and 122. Similarly, N$^+$ source/drain regions 142, 144, and 146 are formed within active region 120. Note that regions 136 and 142, as well as regions 138 and 146 lie immediately adjacent to each other. When forming these pairs of immediately adjacent regions, a small overlap or gap between the regions of each pair can be tolerated because subsequent formed silicide regions electrically connect the two regions within each pair. The overlap or gap between the regions should not become too large as to significantly affect the performance of the transistors.

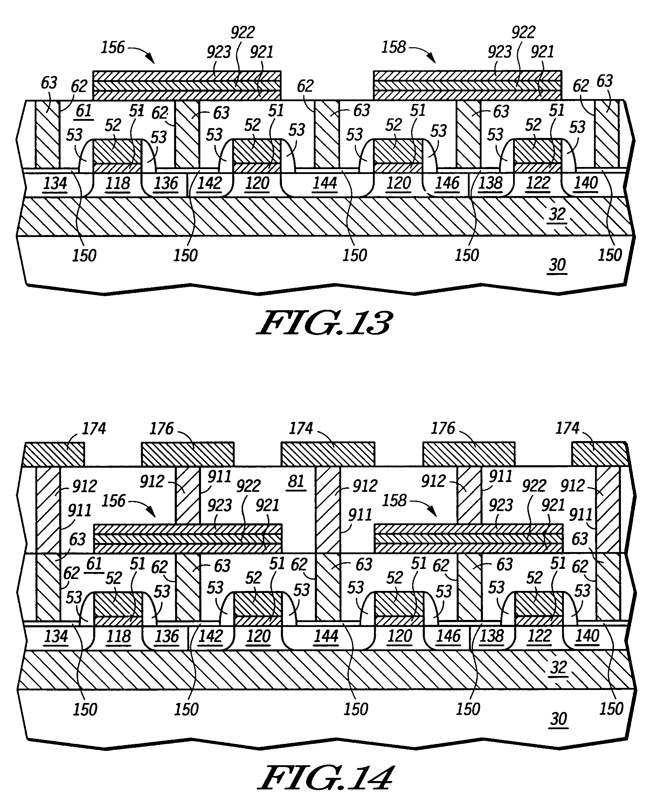

In FIG. 11, self-aligned silicide regions 150 are formed over the source/drain regions. Silicide region 150 can be titanium silicide, cobalt silicide, or the like. Alternatively, other refractory metal-containing materials, such as a refractory-metal nitride (i.e., titanium nitride, tantalum nitride, tungsten nitride, or the like), can be used in place of or conjunction with the silicide material. After silicide regions 150 have been formed, an insulating layer 61 is deposited over the silicide regions 150. The insulating layer 61 is patterned to form contact openings 62 extending to the silicide regions 150 as shown in FIG. 12. Conductive plugs 63 are formed within the openings 62 and contact silicide regions 150.

Ferroelectric capacitors 156 and 158 are formed over the conductive plugs 63 as shown in FIG. 13. Each of ferroelectric capacitors 156 and 158 includes a lower electrode 921, ferroelectric layer 922, and upper electrode 923. Layers 921-923 are patterned similar to the method used to form ferroelectric capacitor 92. The lower electrode layer 921 of ferroelectric capacitor 156 is electrically shorted to source/drain regions 136 and 142. Similarly, lower electrode layer 921 of ferroelectric capacitor 158 is electrically shorted to source/drain regions 146 and 138.

Insulating layer 81 is then formed over the ferroelectric capacitors 156 and 158 as shown in FIG. 14. Contact openings 911 are then formed and are filled with conductive plugs 912. Landing pads 174 and interconnects 176 are formed as shown in FIG. 14. The landing pads 174 and interconnects 176 are formed from the same conductive layer. Interconnects 176 are drive lines for two different memory cells.

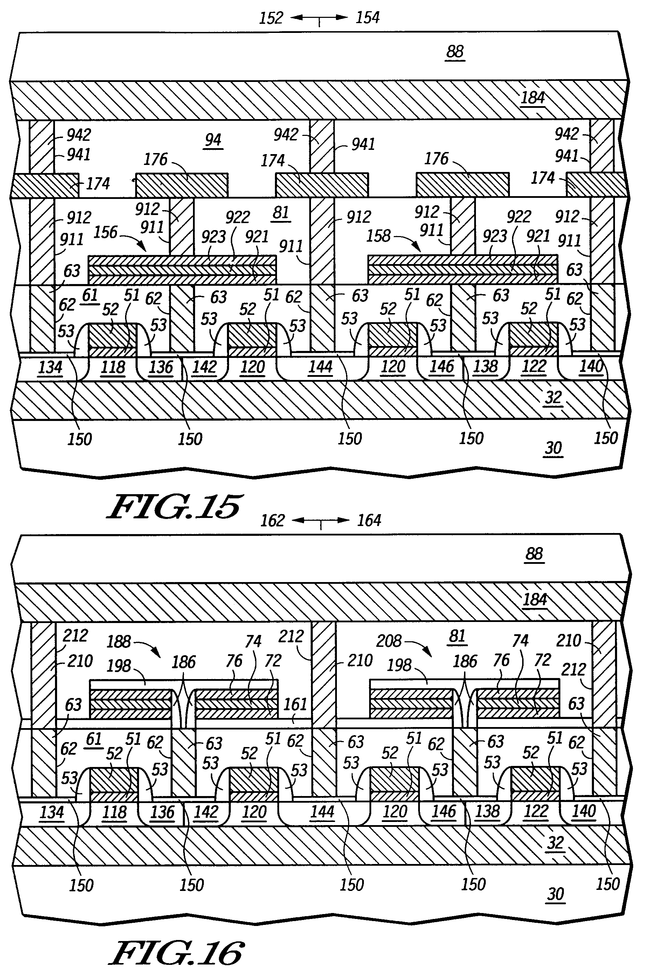

Insulating layer 94 is formed over landing pads 174, interconnect 176, and insulating layer 81 as shown in FIG. 15. Insulating layer 94 is then subsequently planarized using conventional techniques. Via openings 941 are formed and filled to form conductive via plugs 942. Interconnect 184 is formed over the conductive via plugs 942. Interconnect 184 is a bit line for the memory cells shown in FIG. 15. Passivation layer 88 is formed over the interconnect 184. At this point, a substantially completed device is formed. FIG. 15 includes portions of FENVM cells 152 and 154.

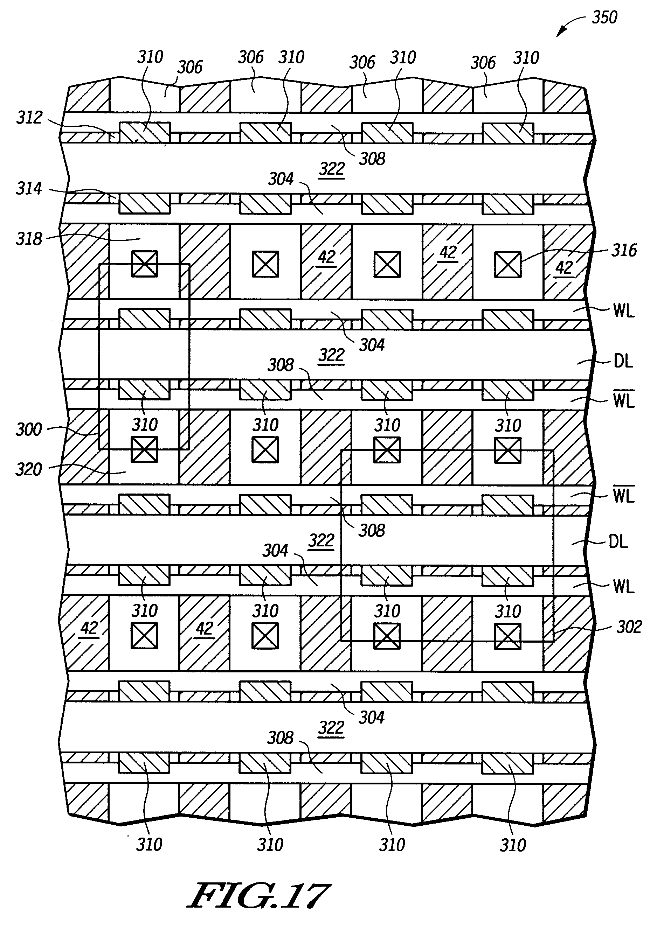

FIG. 16 includes an alternative embodiment that requires only a single level of interconnects to form the device. After forming the conductive plugs 63 in FIG. 12, an insulating layer 161 is formed over the conductive plugs 63 and insulating layer 61. The insulating layer 161 is used to prevent an electrical short from forming between the plugs 63 and lower electrodes 72. Insulating layer 161 typically includes one or more of the films described for insulating layer 61. Layers 72, 74, and 76 are formed and patterned to make ferroelectric capacitors 188 and 208 similar to ferroelectric capacitor 70 in FIG. 6. Portions of the lower electrode layer 72 is part of drive lines for the memory cells 162 and 164. After forming the capacitors 188 and 208, openings are formed through layers 161, 72, 74, and 76 to expose conductive plugs 63 underlying those layers. Insulating spacers 186 are formed within the openings. Conductive members 198 are formed to electrically connect the portions of the upper electrode layer 76 to the conductive plugs 63.

Insulating layer 81 is formed over the ferroelectric capacitors 188 and 208. Via openings 212 and conductive via plugs 210 are formed similar to via openings 911 and conductive via plugs 912. In this embodiment, via openings extend through insulating layer 161. Interconnect 184 and passivation layer 88 are formed over the conductive via plugs 210 and insulating layer 81.

In the embodiment just described, space-efficient contacts are formed through the ferroelectric capacitors 188 and 208. Only one level of interconnects is needed. The space-efficient contact structure sacrifices some capacitor area, but the gain associated with one less interconnect level typically justifies such a design.

FIG. 17 is a top view of a ferroelectric memory cell fabricated using the structure shown in FIG. 15. When forming the memory array 350, field isolation regions 42 are formed into strips having lengths that generally extend from the top to the bottom of FIG. 17. The field isolation regions 42 define active region strips 306 that lie between the field isolation regions 42. Word lines (WL) 304 and complementary word lines ($\overline{WL}$) 308 are formed over and perpendicular to active region strips 306. The ferroelectric capacitor 310 near the upper, left-hand corner of FIG. 17 overlies a portion of source/drain regions 312 and 314 and WL 304 and WL 308. Other ferroelectric capacitors 310 are similar in their positional relationships. Note that $N^+$ source/drain region 312 and $P^+$ source/drain region 314 abut one another underneath ferroelectric capacitor 310.

Drive lines (DL) 322 are electrically connected to the underlying ferroelectric capacitors 310 and have lengths oriented generally perpendicular to the active region strips 306. Bit line contacts 316 are illustrated by $\boxtimes$. Bit lines are not shown in FIG. 17, but have lengths that are generally parallel to the active region strips 306. Contacts are also made to WLs 304, WL s 308, and DLs 322 near the edge of memory array 350, but are not illustrated in FIG. 17.

Memory array 350 can be used for two transistor, one capacitor (2T-1C) memory cells or four transistor, two capacitor (4T-2C) memory cells. Region 300 represents the location of a 2T-1C memory cell. Region 302 represents the location of a four transistor, two capacitor memory cell. If the memory array 350 only has 4T-2C memory cells, bit lines (BLs) and complementary bit lines ($\overline{BL}$ s) are used. For this configuration, BL would overlie one of the active region strips 306 that extends through region 302, and $\overline{BL}$ would overlie the other active region strip 306 that extends through region 302.

Embodiments of the present invention yield benefits to users of those embodiments. Leakage current seen with a bulk substrate does not occur because and the P+ and the N+ source/drain regions that form part of the storage node for a memory cell lie immediately adjacent to the insulating layer 32. This prevents a diode from being formed between these regions and a bulk substrate or well regions within a bulk substrate. Data reversal related to reversed biased diodes should not occur.

The insulating layer 32 also reduces the junction capacitance for the source/drain regions. The lower junction capacitance should make the read (access) and write times shorter. The insulating layer 32 also eliminates the need for guard rings and well-to-well spacing requirements. Valuable substrate areas is saved. Also, field isolation regions do not laterally surround each memory cell. Referring to FIG. 17, active regions are strips that extend for a column of memory cells. Because field isolation regions do not separate memory cells along a column, substrate area is saved.

The substrate 36 is relatively simple to form or obtain. The present invention does not use a sapphire substrate. Problems related to lattice mismatch, fracturing of the sapphire substrate, and aluminum doping from the sapphire are eliminated.

In the foregoing specification, the invention has been described with reference to specific embodiments. However, one of ordinary skill in the art appreciates that various modifications and changes can be made without departing from the scope of the present invention as set forth in the claims below. Accordingly, the specification and figures are to be regarded in an illustrative rather than a restrictive sense, and all such modifications are intended to be included within the scope of the present invention. In the claims, means-plus-function clause(s), if any, cover the structures described herein that perform the recited function(s). The means-plus-function clause(s) also cover structural equivalents and equivalent structures that perform the recited function(s).

## Claims

1. A ferroelectric nonvolatile memory cell (90) comprising:

   a semiconductive base material (30);
   a first insulating layer (32) overlying the semiconductive base material (30);
   a first active region (44) overlying the first insulating layer (32) and having a first conductivity type;
   a second active region (46) overlying the first insulating layer (32) and having a second conductivity type that is opposite the first conductivity type;
   a first source/drain region (55) and a second source/drain region (54), wherein:

      the first and second source/drain regions (55, 54) lie within the first active region (44) and are spaced apart from each other;
      the first and second source/drain regions (55, 54) have the second conductivity type;

   a third source/drain region (56) and a fourth source/drain region (57), wherein:

      the third and fourth source/drain regions (56, 57) lie within the second active region (46) and are spaced apart from each other;
      the third and fourth source/drain regions (56, 57) have the first conductivity type;

   a first gate electrode (52) and a second gate electrode (52) overlying the first and second active regions (44, 46), respectively;
   a second insulating layer (61) overlying the first and second active regions (44, 46) and first and second gate electrodes (52); and
   a first ferroelectric capacitor (92) overlying the second insulating layer (61) and having a first capacitor electrode (92) and a second capacitor electrode (923), wherein one of the first and second capacitor electrodes (921, 923) is electrically connected to the first and third source/drain regions (55, 56).

2. A ferroelectric nonvolatile memory cell (302) comprising:

   a semiconductive base material (30);
   a first insulating layer (32) overlying the semiconductive base material (30);
   a first active region (118) overlying the first insulating layer (32) and having a first conductivity type;
   a second active region (120) overlying the first insulating layer (32) and having a second conductivity type that is opposite the first conductivity type;
   a third active region (118) overlying the first insulating layer (32) and having the first conductivity type;
   a fourth active region (120) overlying the first insulating layer (32) and having the second conductivity type;
   a first source/drain region (136) and a second source/drain region (134), wherein:

      the first and second source/drain regions (136, 134) lie within the first active region (118) and are spaced apart from each other;
      the first and second source/drain regions (136, 134) have the second conductivity type;

a third source/drain region (142) and a fourth source/drain region (144), wherein:

the third and fourth source/drain regions (142, 144) lie within the second active region and are spaced apart from each other; and
the third and fourth source/drain regions (142, 144) have the first conductivity type;

a fifth source/drain region (136) and a sixth source/drain region (134), wherein:

the fifth and sixth source/drain regions (136, 134) lie within the third active region (118) and are spaced apart from each other; and
the fifth and sixth source/drain regions (136, 134) have the second conductivity type;

a seventh, source/drain region (142) and an eighth source/drain region (144), wherein:

the seventh and eighth source/drain regions (142, 144) lie within the fourth active region (120) and are spaced apart from each other; and
the seventh and eighth source/drain regions (142, 144) have the first conductivity type;

a first gate electrode (52), a second gate electrode (52), a third gate electrode (52), and a fourth gate electrode (52) overlying the first, second, third, and fourth active regions (118, 120), respectively;
a second insulating layer (61) overlying the first, second, third, and fourth active regions (118, 120) and first, second, third, and fourth gate electrodes (52);
a first ferroelectric capacitor (156) overlying the second insulating layer (61) and having a first capacitor electrode (921) and a second capacitor electrode (923), wherein one of the first and second capacitor electrodes (921, 923) is electrically connected to the first and third source/drain regions (136, 142); and
a second ferroelectric capacitor (156) overlying the second insulating layer (61) and having a third capacitor electrode (921) and a fourth capacitor electrode (923), wherein one of the third and fourth capacitor electrodes (921, 923) is electrically connected to the fifth and seventh source/drain regions (136, 142).

3. A process for forming a ferroelectric nonvolatile memory cell (80) comprising the steps of:

providing a substrate having:

a semiconductive base material (30);
a first insulating layer overlying (32) the semiconductive base material (30);
a first active region (44) overlying the first insulating layer (32) and having a first conductivity type; and
a second active region (46) overlying the first insulating layer (32) and having a second conductivity type that is opposite the first conductivity type;

forming a first gate electrode (52) and a second gate electrode (52), wherein the first and second gate electrodes (52) overlie the first and second active regions (44, 46), respectively;

forming a first source/drain region (55) and a second source/drain region (54) within the first active region (44), wherein:

the first and second source/ drain regions (55, 54) are spaced apart from each other; and
the first and second source/drain regions (55, 54) have the second conductivity type;

forming a third source/drain region (56) and a fourth source/drain region (57) within the second active region (46), wherein:

the third and fourth source/ drain regions (56, 57) are spaced apart from each other; and
the third and fourth source/drain regions (56, 57) have the first conductivity type;

forming a second insulating layer (61) over the first and second active regions (44, 46) and the first and second gate electrodes (52); and

forming a first ferroelectric capacitor (91) over the second insulating layer (61) and having a first capacitor electrode (921) and a second capacitor electrode (923), wherein one of the first and second capacitor electrodes is electrically connected to the first and third source/drain regions (55, 56).

4. A process for forming a ferroelectric nonvolatile memory cell (302) comprising the steps of:

providing a substrate having:

a semiconductive base material (30);
a first insulating layer (32) overlying the semiconductive base material (30);
a first active region (118) overlying the first insulating layer (32) and having a first conductivity type;

a second active region (120) overlying the first insulating layer (32) and having a second conductivity type that is opposite the first conductivity type;

a third active region (118) overlying the first insulating layer (32) and having the first conductivity type; and

a fourth active region (120) overlying the first insulating layer (32) and having the second conductivity type;

forming a first gate electrode (52), a second gate electrode (52), a third gate electrode (52), and a fourth gate electrode (52), over the first, second, third, and fourth active regions (118, 120), respectively;

forming a first source/drain region (136), a second source/drain region (134), a third source/drain region (136), and a fourth source/drain region (134), wherein:

the first and second source/ drain regions (136, 134) lie within the first active region (118) and are spaced apart from each other;
the third and fourth source/ drain regions (136, 134) lie within the third active region (136) and are spaced apart from each other; and
the first, second, third, and fourth source/drain regions (136, 134) have the second conductivity type;

forming a fifth source/drain region (142), a sixth source/drain region (144), a seventh source/drain region (142), and an eighth source/drain region (144), wherein:

the fifth and sixth source/ drain regions (142, 144) lie within the second active region (120) and are spaced apart from each other;
the seventh and eighth source/ drain regions (142, 144) lie within the fourth active region (120) and are spaced apart from each other; and
the fifth, sixth, seventh, and eighth source/drain regions (142, 144) have the first conductivity type;

forming a second insulating layer (61) over the first, second, third, and fourth active regions (118, 120) and the first, second, third, and fourth gate electrodes (52); and

forming a first ferroelectric capacitor (156) and a second ferroelectric capacitor (156) over the second insulating layer (61), wherein:

the first ferroelectric capacitor (156) has a first capacitor electrode (921) and a second capacitor electrode (923), wherein one of the first and second capacitor electrodes (921, 923) is electrically connected to the first and fifth source/drain regions (136, 142); and
the second ferroelectric capacitor (156) has a third capacitor electrode (921) and a fourth capacitor electrode (923), wherein one of the third and fourth capacitor electrodes (921, 923) is electrically connected to the third and seventh source/drain regions (136, 142).

5. The memory cell of claim 1 or 2, wherein the first and third source/drain regions lie immediately adjacent to each other.

6. The memory cell of claim 5, further comprising a refractory metal-containing member (150) overlying the first and third source/drain regions, wherein the refractory metal-containing member (150) electrically connects the first and third source/drain regions to each other.

7. The memory cell of claim 1 or 2, wherein:

the second insulating layer (61) includes a first opening overlying (62) at least one of the first and third source/drain regions; and
the memory cell includes a conductive member (63) that lies within the first opening and electrically connects the at least one of the first and third source/drain regions to the first capacitor electrode (921).

8. The memory cell (90) of claim 1, wherein:

the ferroelectric capacitor (92) includes a ferroelectric layer (922);
a first opening (62) extends through the ferroelectric layer (922), the first capacitor electrode (921), and the second insulating layer (61); and
the memory cell includes a conductive member (66, 198) within the first opening that is electrically connected to the at least one of the first and third source/drain regions (55, 56) and to the second capacitor electrode (923).

9. A ferroelectric nonvolatile memory cell as substantially described herein.

10. A process for forming a ferroelectric nonvolatile memory cell as substantially described herein.

*FIG.1*
-PRIOR ART-

*FIG.2*
-PRIOR ART-

*FIG.3*

FIG.4

FIG.5

FIG.6

*FIG.7*

*FIG.8*

FIG.9

FIG.10

FIG.11

FIG.12

## FIG.13

## FIG.14

152 ←→ 154

**88**

**184**

*942*
*941*
**94**
*942*
*941*
*176*
*941*
*174*
*176*
*942*
*941*
*174*
*174*

*912*
*911*
*912*
*911*
**81**
*912*
*912*
*911*
*922*
*912*
*911*
*156*
*922*
*921*
*923*
*921*
*911*
*158*
*923*
*921*
*63*
*63*

*62* *61* *51* *62*
*52* *51*
*53* *52* *53*
*53* *63* *51* *62*
*52* *53*
*63* *51* *62*
*53* *52* *53*
*63* *51* *62*
*53* *52* *53*

**134** **118** **136** **142** **120** **144** **120** **146** **138** **122** **140**

**32**

*150* *150* *150* *150* *150*

**30**

# FIG.15

162 ←→ 164

**88**

**184**

*212*
*210*
*188*
*198*
*186*
*74* *212*
*76* *72*
*208*
*81*
*74* *210*
*210* *198*
*186* *76* *72*
*212*
*63*
*161*
*63*

*62* *61* *51* *62*
*52*
*53* *53*
*63* *51* *62*
*53* *52* *53*
*63* *51* *62*
*53* *52* *53*
*63* *51* *62*
*53* *52* *53*

**134** **118** **136** **142** **120** **144** **120** **146** **138** **122** **140**

**32**

*150* *150* *150* *150* *150*

**30**

# FIG.16

FIG.17

## EUROPEAN SEARCH REPORT

**European Patent Office**

**Application Number**

EP 97 10 2512

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US 5 373 463 A (JONES JR ROBERT E) 13 December 1994 <br> * column 8, line 7 - line 51; figure 5 * | 1-4 | H01L27/115 <br> H01L27/12 |
| A | US 5 444 282 A (YAMAGUCHI YASUO ET AL) 22 August 1995 <br> * column 8, line 1 - line 44; figure 8 * | 1-4 | |
| A | US 5 406 102 A (OASHI TOSHIYUKI) 11 April 1995 <br> * column 1, line 65 - column 3, line 2; figures 32,33 * | 1-4,7,8 | |
| A | US 5 359 219 A (HWANG JEONG-MO) 25 October 1994 <br> * column 4, line 26 - line 38; figure 1G * | 1-6 | |

**TECHNICAL FIELDS SEARCHED (Int.Cl.6)**

H01L

The present search report has been drawn up for all claims

| Place of search | Date of completion of the search | Examiner |
|---|---|---|
| THE HAGUE | 14 May 1997 | Albrecht, C |

EPO FORM 1503 03.82 (P04C01)